# EUROPÄISCHE PATENTSCHRIFT

(11) **EP 1 507 885 B1**
(45) Veröffentlichungstag und Bekanntmachung des Hinweises auf die Patenterteilung: **29.06.2016**
(21) Anmeldenummer: 03724886.1
(22) Anmeldetag: 09.05.2003
(51) Int. Cl.: C23C 16/04, B08B 9/42, B65G 47/84

(54) **VERFAHREN UND VORRICHTUNG ZUR PLASMABEHANDLUNG VON WERKSTÜCKEN**
METHOD AND DEVICE FOR PLASMA TREATMENT OF WORK PIECES
PROCEDE ET DISPOSITIF POUR LE TRAITEMENT AU PLASMA DE PIECES

(30) Priorität: 24.05.2002 DE 10223288; 11.03.2003 DE 10310470
(43) Veröffentlichungstag der Anmeldung: 23.02.2005
(73) Patentinhaber: KHS Corpoplast GmbH, 22145 Hamburg (DE)
(72) Erfinder: LITZENBERG, Michael, 21502 Geesthacht (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55278 Hahnheim (DE); LÜTTRINGHAUS-HENKEL, Andreas, 64289 Darmstadt (DE); BICKER, Matthias, 55126 Mainz (DE); KLEIN, Jürgen, 55127 Mainz (DE); LEWIN, Frank, 22889 Tangstedt (DE)
(74) Vertreter: Meissner Bolte Partnerschaft mbB
(86) Internationale Anmeldenummer: PCT/DE2003/001510
(87) Internationale Veröffentlichungsnummer: WO 2003/100119

(56) Entgegenhaltungen:
- WO-A-00/58631
- WO-A-01/31680
- WO-A-95/22413
- WO-A-99/17334
- DE-U- 29 713 510

## Beschreibung

Die Erfindung betrifft ein Verfahren zur Plasmabehandlung von Werkstücken, bei dem das Werkstück in eine zumindest teilweise evakuierbare Plasmakammer einer Behandlungsstation eingesetzt wird und bei dem das Werkstück innerhalb der Behandlungsstation von einem Halteelement positioniert wird sowie bei dem das Werkstück durch das Halteelement derart beaufschlagt wird, daß das Werkstück in Richtung einer Kavitätenlängsachse positionsveränderlich geführt und in einer Behandlungspositionierung mit einem Mündungsbereich gegen eine Dichtung gedrückt wird.

Die Erfindung betrifft darüber hinaus eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und mindestens ein Halteelement zur Positionierung des Werkstückes aufweist und bei der das Halteelement mindestens in Richtung einer Kavitätenlängsachse positionsveränderlich angeordnet ist.

Derartige Verfahren und Vorrichtungen werden beispielsweise eingesetzt, um Kunststoffe mit Oberflächenbeschichtungen zu versehen. Insbesondere sind auch bereits derartige Verfahren und Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

Bei der überwiegenden Anzahl der bekannten Verfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOₓ verwendet. Derartige Barriereschichten verhindern ein Eindringen von Sauerstoff in die verpackten Flüssigkeiten sowie ein Austreten von Kohlendioxid bei CO₂-haltigen Flüssigkeiten.

In der WO 0131680 A wird eine Einrichtung zur Plasmabehandlung von flaschenförmigen Behältern beschrieben. Die Flaschen werden in einem geöffneten Zustand der Plasmastation in eine Halterung eines Stationsdeckels eingesetzt und anschließend gemeinsam mit dem Stationsdeckel in Richtung auf die Plasmakammer positioniert.

Aus der DE 297 13 510 U ist es bekannt, im Bereich einer Fülleinrichtung für Flaschen zangenartige Halteelemente zu verwenden.

Die bislang bekannten Verfahren und Vorrichtungen sind noch nicht in ausreichender Weise dafür geeignet, für eine Massenproduktion eingesetzt zu werden, bei der sowohl ein geringer Beschichtungspreis je Werkstück als auch eine hohe Produktionsgeschwindigkeit erreicht werden muß.

Aufgabe der vorliegenden Erfindung ist es daher, ein Verfahren der einleitend genannten Art derart anzugeben, daß eine Handhabung der zu behandelnden Werkstücke mit hoher Geschwindigkeit und großer Zuverlässigkeit unterstützt wird.

Diese Aufgabe wird erfindungsgemäß dadurch gelöst, daß das Werkstück durch mindestens zwei relativ zueinander positionierbare Klemmelemente des Halteelementes derart beaufschlagt wird, daß das Werkstück von einem Klemmraum zwischen den Klemmelementen aufgenommen wird, daß die Positionierung der Klemmelemente in einer horizontalen Richtung durchgeführt wird und daß das Werkstück von die Klemmelemente bereitstellenden zangenartigen Haltearmen positioniert wird und daß das Halteelement durch eine Verschiebung einer Kammerwandung der Plasmastation positioniert wird.

Weitere Aufgabe der vorliegenden Erfindung ist es, eine Vorrichtung der einleitend genannten Art derart zu konstruieren, daß eine einfache Bewegungskinematik der zu behandelnden Werkstücke unterstützt wird.

Diese Aufgabe wird erfindungsgemäß dadurch gelöst, daß ein als Teil des Halteelementes ausgebildetes Sockelelement eine Dichtung zur Beaufschlagung eines Mündungsbereiches des Werkstückes aufweist, daß das Halteelement mindestens zwei relativ zueinander positionierbare Klemmelemente aufweist, die relativ zueinander mit einem einen Klemmraum bereitstellenden Abstand zur Aufnahme des Werkstückes angeordnet sind, daß die Klemmelemente in einer horizontalen Richtung positionierbar sind und daß die Klemmelemente von zangenartig angeordneten Haltearmen bereitgestellt sind und daß das Halteelement von einer Kammerwandung der Plasmastation positionierbar ist.

Durch die Positionierung der Werkstücke innerhalb der Behandlungsstation unter Verwendung des Halteelementes ist es möglich, die zu behandelnden Werkstücke innerhalb einer Anlage zur Durchführung des Verfahrens, während der Durchführung des Verfahrens sowie während der Durchführung einer. Eingabe und einer Ausgabe im Bereich der Behandlungsstation auf einem im wesentlichen gleichbleibenden Höhenniveau zu transportieren. Erst innerhalb der Behandlungsstation erfolgt eine Veränderung des Höhenniveaus des Werkstückes derart, daß dieses mit seinem Mündungsbereich gegen die Dichtung geführt wird, so daß eine Abdichtung gewährleistet ist. Die Veränderung der Höhenpositionierung des Werkstückes kann zeitsynchron mit der Durchführung anderer Bewegungsvorgänge erfolgen, so daß kein zusätzlicher Zeitbedarf verursacht wird.

Der verfahrenstechnische Ablauf bei der Handhabung der Werkstücke erfolgt derart, daß zunächst für ein Einsetzen der Werkstücke in die Plasmakammer eine Öffnung der Plasmakammer zumindest soweit erfolgt, daß die Werkstücke an das Halteelement übergeben werden können. Insbesondere ist daran gedacht, die Übergabe derart durchzuführen, daß die Werkstücke von einem Transferelement an das Halteelement übergeben werden, so daß kein eigenständiger Bewegungsantrieb für das Halteelement erforderlich ist. Nach einer Positionierung der Werkstücke durch das Halteelement innerhalb der Plasmakammer erfolgt zu einem vorgebbaren Zeitpunkt eine Absenkung des Halteelementes und hierdurch eine Abdichtung des Innenraumes des Werkstückes relativ zum Innenraum der Plasmakammer.

Eine derartige Abdichtung kann sowohl bereits zu einem Beginn des Evakuierungsvorganges als auch nach einer bereits durchgeführten Teilevakuierung erfolgen. Eine Abdichtung erst nach einer Teilevakuierung weist den Vorteil auf, daß ein Innenraum des Werkstückes und der weitere Innenraum der Plasmakammer zunächst gemeinsam evakuiert werden können und daß in einem zweiten Evakuierungsschritt nach einer Abdichtung des Innenraumes des Werkstückes der Unterdruck im Bereich des Innenraumes des Werkstückes unterschiedlich zum Unterdruck im weiteren Innenraum der Plasmakammer vorgegeben werden kann. Insbesondere ist hierbei daran gedacht, den Unterdruck im Innenraum des Werkstückes tiefer als im weiteren Innenraum der Plasmakammer vorzugeben.

Nach einer Durchführung des Bearbeitungsvorganges und einem Wiedererreichen des Umgebungsdruckes innerhalb der Plasmakammer sowie innerhalb des Werkstückes erfolgt eine Übergabe des Werkstückes vom Halteelement an ein weiteres Transferelement. Der Übergabevorgang wird vorzugsweise derart durchgeführt, daß sich das Transferelement an das Halteelement annähert, das Werkstück übernimmt und dann das Werkstück abtransportiert.

Eine günstige Schwerkrafteinleitung wird dadurch unterstützt, daß die Positionierung der Klemmelemente in einer horizontalen Richtung durchgeführt wird.

Eine einfache Durchführung von Übergabevorgängen wird dadurch unterstützt, daß das Werkstück von zangenartigen Haltearmen positioniert wird.

Bei einer Beschichtung von hohlen Werkstücken, die mit ihrer Mündung nach unten angeordnet sind, erweist es sich als vorteilhaft, daß eine Evakuierung einer Kavität der Plasmastation durch den Kammerboden hindurch erfolgt.

Eine gerätetechnisch einfache Realisierung wird ebenfalls dadurch unterstützt, daß durch den Kammerboden hindurch Prozeßgas zugeführt wird.

Eine schnelle und gleichmäßige Verteilung des Prozeßgases in einem Innenraum des Werkstückes kann dadurch erreicht werden, daß das Prozeßgas durch eine Lanze hindurch in einen Innenraum des Werkstückes zugeführt wird.

Ein einfaches Öffnen und Schließen des Halteelementes wird dadurch unterstützt, daß das Werkstück von verschwenkbar gelagerten Haltearmen positioniert wird. zur Vorgabe einer automatischen Einnahme einer Halterungspositionierung wird vorgeschlagen, daß die Haltearme von Federn in eine Arretierungspositionierung gedrückt werden.

Ein Einsetzen des Werkstückes in das Halteelement wird dadurch unterstützt, daß die Haltearme bei einem Einführen des Werkstückes in den Klemmraum auseinander gedrückt werden.

Zur Erleichterung einer Entnahme des Werkstückes aus dem Halteelement wird vorgeschlagen, daß die Haltearme bei einem Herausziehen des Werkstückes aus dem Klemmraum auseinander gedrückt werden. Insbesondere ist daran gedacht, das Auseinanderdrücken durch einen unmittelbaren Kontakt zwischen dem Werkstück und den Haltearmen hervorzurufen.

Zur Vermeidung einer ungesteuerten Bewegung des Halteelementes in einem geschlossenen Zustand der Plasmakammer wird vorgeschlagen, daß Arretierungselemente zur Fixierung der Haltearme gemeinsam mit der Kammerwandung positioniert werden.

Eine sehr sichere Fixierung des Werkstückes kann dadurch erreicht werden, daß etwa auf einem gleichen Höhenniveau wie die Haltearme ein Anschlagelement zur Fixierung des Werkstückes angeordnet wird.

Zur Unterstützung einer steuerbaren Zündung des Plasmas wird vorgeschlagen, daß im Bereich des Kammerdeckels von einem Mikrowellengenerator erzeugte Mikrowellen in die Kavität eingeleitet werden.

Eine typische Anwendung besteht darin, daß ein Werkstück aus einem thermoplastischen Kunststoff behandelt wird. Insbesondere ist daran gedacht daß ein Innenraum des Werkstückes behandelt wird.

Ein umfangreiches Anwendungsgebiet wird dadurch erschlossen, daß als Werkstück ein Behälter behandelt wird.

Insbesondere ist dabei daran gedacht, daß als Werkstück eine Getränkeflasche behandelt wird.

Eine hohe Produktionsrate bei großer Zuverlässigkeit und hoher Produktqualität kann dadurch erreicht werden, daß die mindestens eine Plasmastation von einem rotierenden Plasmarad von einer Eingabepositionierung in eine Ausgabepositionierung überführt wird.

Eine Vergrößerung der Produktionskapazität bei nur geringfügig gesteigertem gerätetechnischen Aufwand kann dadurch erreicht werden, daß von einer Plasmastation mehrere Kavitäten bereitgestellt werden.

Für Anwendungen im Bereich der Herstellung von Verpackungen für Flüssigkeiten erweist es sich als besonders vorteilhaft, daß das Werkstück in einem Mündungsbereich von den Haltearmen fixiert wird.

Eine typische Anwendung wird dadurch definiert, daß als Plasmabehandlung eine Plasmabeschichtung durchgeführt wird.

Insbesondere ist daran gedacht, daß die Plasmabehandlung unter Verwendung eines Niederdruckplasmas durchgeführt wird.

Bei einer Beschichtung von Werkstücken aus Kunststoff erweist es sich als vorteilhaft, daß eine Plasmapolymerisation durchgeführt wird.

Eine gute Oberflächenhaftung wird dadurch unterstützt, daß durch das Plasma mindestens zum Teil organische Substanzen abgeschieden werden.

Besonders vorteilhafte Verwendungseigenschaften bei Werkstücken zur Verpackung von Lebensmitteln können dadurch erreicht werden, daß durch das Plasma mindestens zum Teil anorganische Substanzen abgeschieden werden.

Bei der Behandlung von Verpackungen ist insbesondere daran gedacht, daß durch das Plasma eine Substanz zur Verbesserung von Barriereeigenschaften des Werkstückes abgeschieden wird.

Zur Unterstützung einer hohen Gebrauchsqualität wird vorgeschlagen, daß zusätzlich ein Haftvermittler zur Verbesserung eines Anhaftens der Substanz auf einer Oberfläche des Werkstückes abgeschieden wird.

Eine hohe Produktivität kann dadurch unterstützt werden, daß in einer gemeinsamen Kavität mindestens zwei Werkstücke gleichzeitig behandelt werden.

Ein weiteres Anwendungsgebiet besteht darin, daß als Plasmabehandlung eine Plasmasterilisation durchgeführt wird.

Ebenfalls ist daran gedacht, daß als Plasmabehandlung eine Oberflächenaktivierung des Werkstückes durchgeführt wird. Eine belastungsfähige Bereitstellung der Federkräfte kann dadurch erfolgen, daß die Federverspannungen von Schenkelfedern bereitgestellt sind. Alternativ können die Federkräfte auch von Druckfedern erzeugt werden.

Zur Verhinderung einer ungewollten Veränderung einer Positionierung des Werkstückes innerhalb der Plasmakammer wird vorgeschlagen, daß die Haltearme im Bereich ihrer den Fixierungsvorsprüngen abgewandten Ausdehnung mit Arretierstegen versehen sind.

Eine einfache mechanische Realisierung kann dadurch erfolgen, daß die Arretierstege von Arretierelementen festsetzbar sind.

Zur Unterstützung einer dauerhaften Betriebsfähigkeit auch unter Berücksichtigung konstruktiver Toleranzen wird vorgeschlagen, daß die Arretierelemente aus einem gehärteten Material ausgebildet sind.

Eine weitere Verbesserung der Positioniersicherheit des Werkstückes kann dadurch hervorgerufen werden, daß das Halteelement mit einem Anschlagelement für das Werkstück versehen ist.

Für eine Plasmabehandlung von flaschenartigen Werkstücken erweist es sich als besonders vorteilhaft, daß das Anschlagelement und die Fixierungsvorsprünge auf einem Höhenniveau zur Beaufschlagung eines flaschenförmigen Werkstükkes zwischen dessen Stützring und dessen Schulterbereich angeordnet sind.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabeund Ausgaberädern gekoppelt ist.
- Fig. 2: eine Anordnung ähnlich zu Fig. 1, bei der die Plasmastation jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine Darstellung entsprechend Fig. 5 mit geöffneter Plasmakammer,
- Fig. 8: einen Vertikalschnitt gemäß Schnittlinie VIII-VIII in Fig. 7,
- Fig. 9: eine vergrößerte Darstellung der Plasmakammer mit zu beschichtender Flasche gemäß Fig. 6,

- Fig. 10: eine perspektivische Darstellung einer mit zwei Halteelementen versehenen Tragplatte, die für eine Behandlungsstation mit zwei Kavitäten vorgesehen ist,
- Fig. 11: eine vergrößerte perspektivische Darstellung eines der Halteelemente gemäß Figur 10 und
- Fig. 12: einen Querschnitt gemäß Schnittlinie XII - XII in Figur 11.

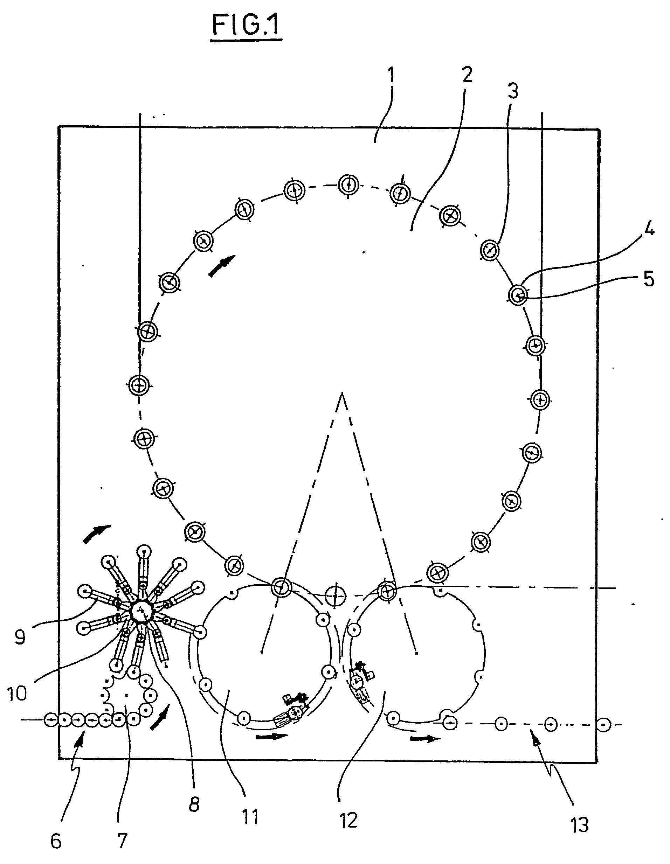

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

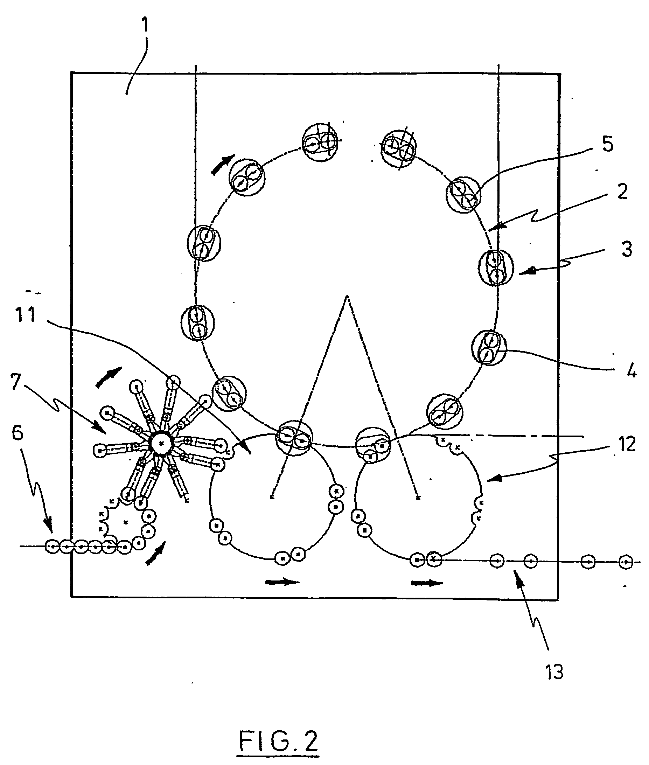

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller werkstücke (5) gewährleistet ist. Insbesondere ist hierbei daran gedacht, die Teilkavitäten zumindest durch separate Mikrowelleneinkopplungen gegeneinander abzugrenzen.

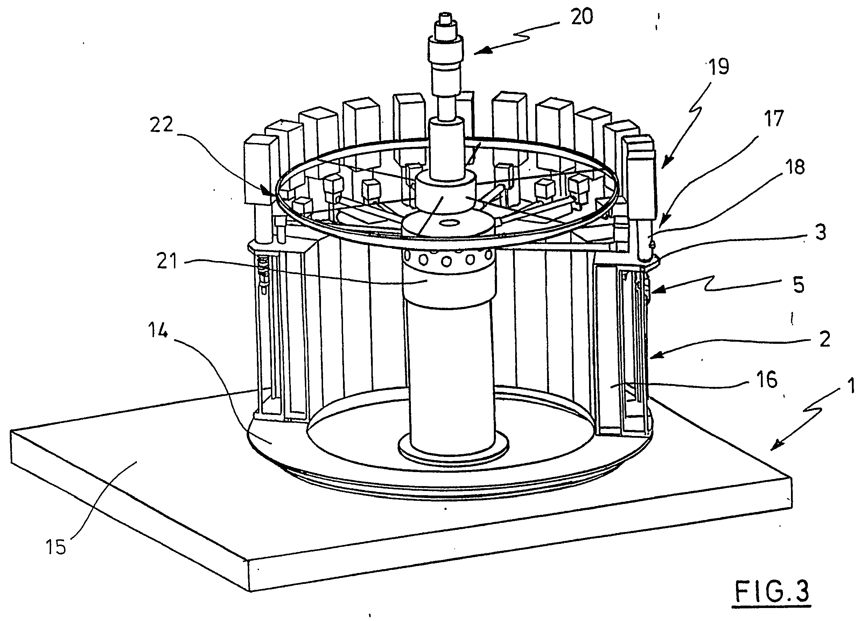

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

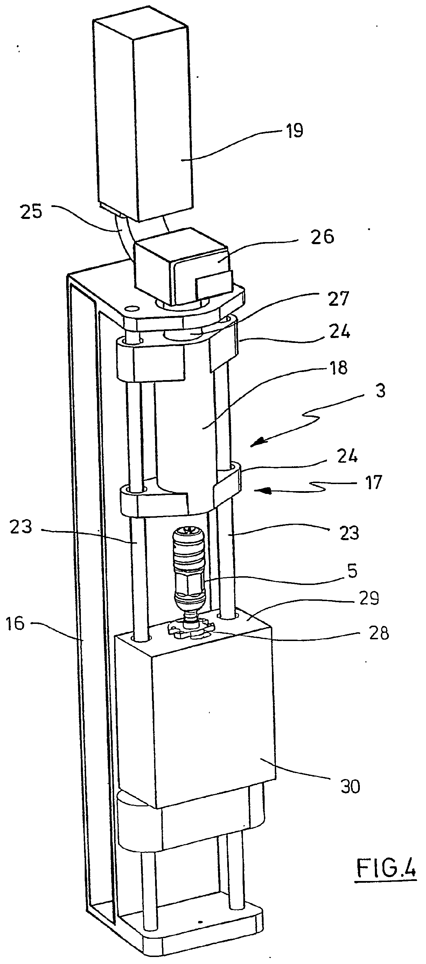

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdekkels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird im Bereich eines Positionierelementes (28) gehaltert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

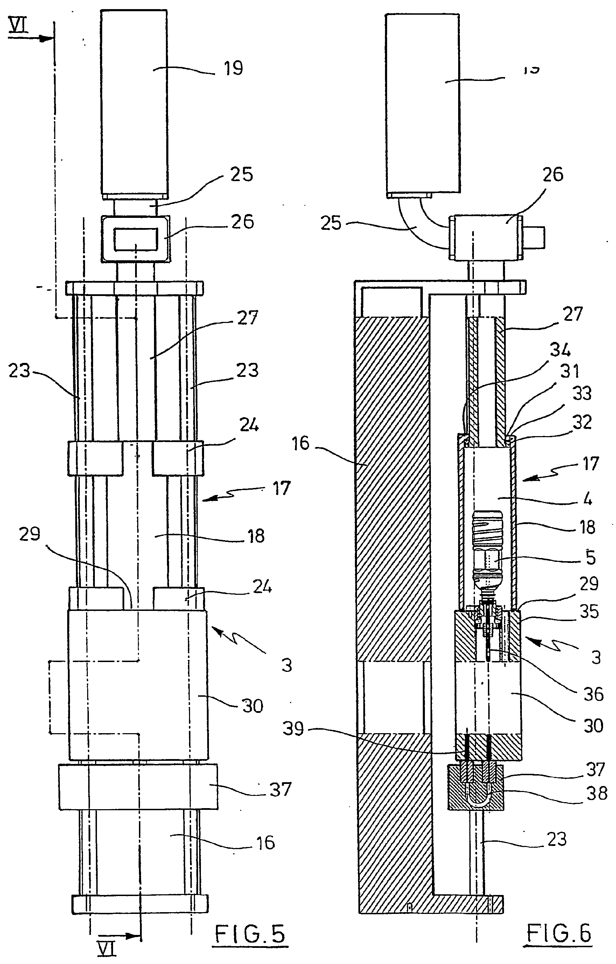

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersokkels (30) eine hohle Lanze (36) angeordnet, die in den Innenraum des Werkstückes (5) hineinverfahrbar ist. Zur Durchführung einer Positionierung der Lanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

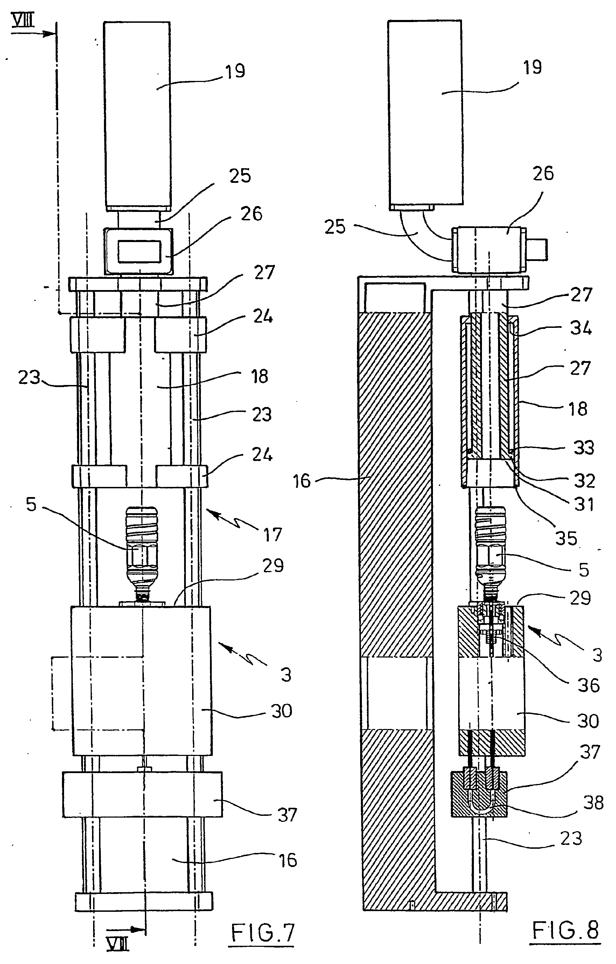

Fig. 7 und Fig. 8 zeigen die Anordnung gemäß Fig. 5 und Fig. 6 in einem angehobenen Zustand der Kammerwandung (18). In diesem Positionierungszustand der Kammerwandung (18) ist es problemlos möglich, das behandelte Werkstück (5) aus dem Bereich der Plasmastation (3) zu entfernen und ein neues zu behandelndes Werkstück (5) einzusetzen. Alternativ zu der in den Zeichnungen dargestellten Positionierung der Kammerwandung (18) in einem durch Verschiebung nach oben erreichten geöffneten Zustand der Plasmakammer (17) ist es auch möglich, den Öffnungsvorgang durch eine Verschiebung einer konstruktiv modifizierten hülsenförmigen Kammerwandung in vertikaler Richtung nach unten durchzuführen.

Im dargestellten Ausführungsbeispiel besitzt der Kopplungskanal (27) eine zylinderförmige Gestaltung und ist im wesentlichen koaxial zur Kammerwandung (18) angeordnet.

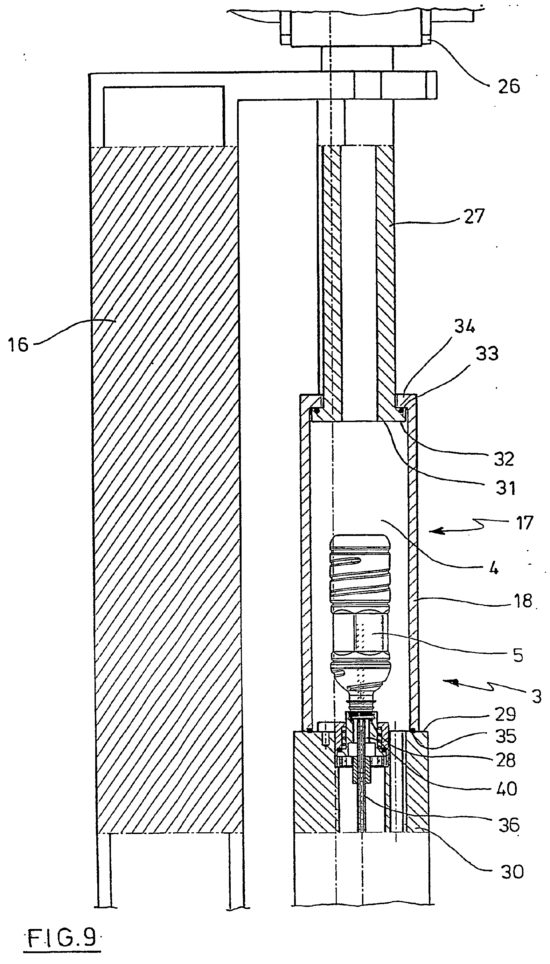

Fig. 9 zeigt den Vertikalschnitt gemäß Fig. 6 in einer vergrößerten teilweisen Darstellung in einer Umgebung der Kammerwandung (18). Zu erkennen ist insbesondere das Übergreifen des Innenflansches (34) der Kammerwandung (18) über den Flansch (32) des Kammerdeckels (31) und die Halterung des Werkstückes (5) durch das Positionierelement (28). Darüber hinaus ist zu erkennen, daß die Lanze (36) durch eine Ausnehmung (40) des Positionierelementes (28) hindurchgeführt ist.

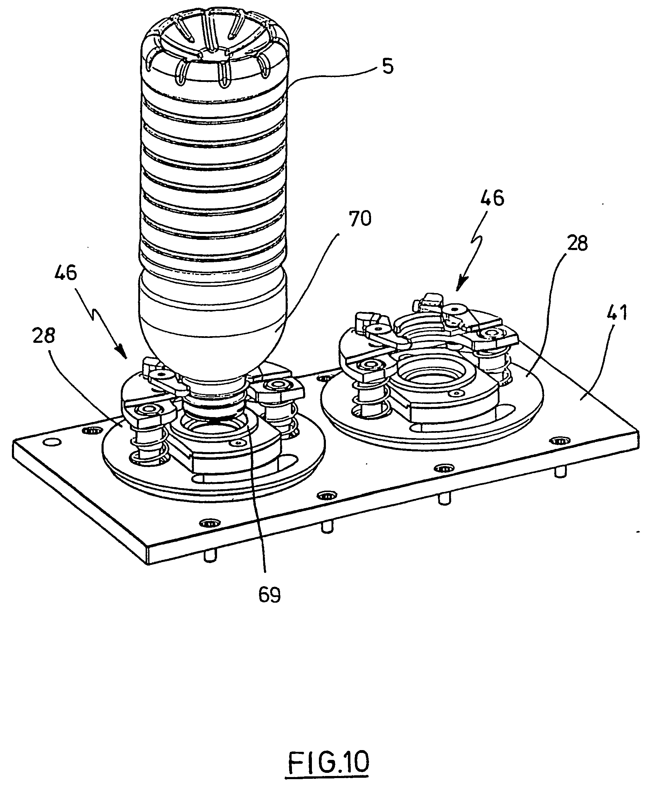

Fig. 10 zeigt die Anordnung von zwei Positionierelementen (28) im Bereich einer gemeinsamen Tragplatte (41). Die Tragplatte (41) mit den beiden Positionierelementen (28) ist zur Verwendung im Bereich einer Plasmastation (3) zur gleichzeitigen Beschichtung von zwei Werkstücken (5) vorgesehen. Das in Figur 10 dargestellte Positionierelement (28) kann aber auch für Plasmastationen (3) verwendet werden, in denen lediglich ein Werkstück (5) oder mehr als zwei Werkstücke (5) gleichzeitig beschichtet oder behandelt werden. Jedes der Positionierelemente (28) ist mit einem Halteelement (46) zur unmittelbaren Beaufschlagung der Werkstücke (5) versehen.

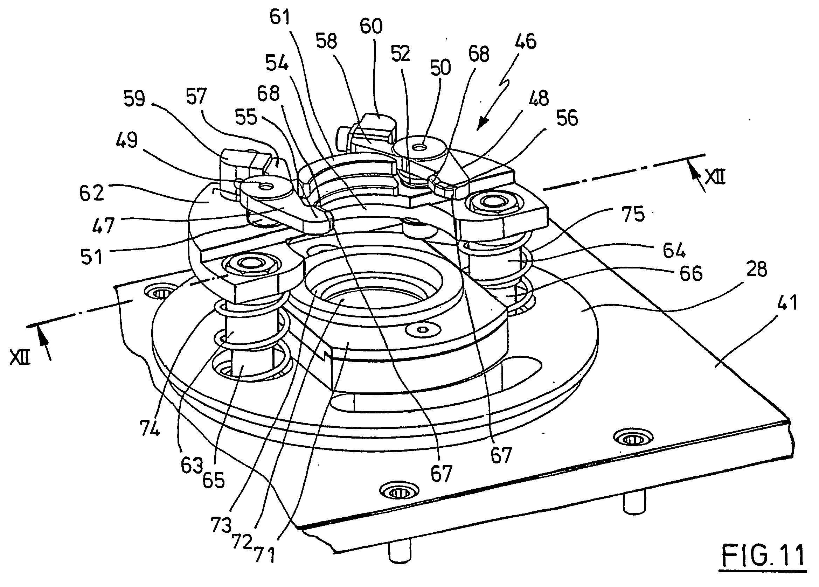

Der Detailaufbau der Positionierelemente (28) ist in Fig. 11 in einer vergrößerten perspektivischen Darstellung veranschaulicht. Das Halteelement (46) ist zangenartig ausgebildet und besitzt zwei verschwenkbar gelagerte Haltearme (47, 48). Die Haltearme (47, 48) sind relativ zu Drehachsen (49, 50) verschwenkbar. Zur Gewährleistung einer automatischen Fixierung des Werkstückes (5) durch das Halteelement (46) werden die Haltearme (47, 48) von Federn (51, 52) in eine jeweilige Haltepositionierung gedrückt. Vorzugsweise ist an die Verwendung von Schenkelfedern (51, 52) gedacht.

Das Halteelement (46) ist oberhalb des Kammersockels (30) angeordnet, so daß nach einem Anheben der Kammerwandung (18) eine seitliche Zugänglichkeit des Halteelementes (46) gegeben ist. Das Werkstück (5) kann hierdurch von einem außerhalb der Plasmastation (3) angeordnetem Positionierelement an das Halteelement (46) übergeben werden, ohne daß vor der Übergabe eine Hubbewegung des Werkstückes (5) in Richtung einer Kavitätenlängsachse (53) erfolgen muß.

Aus Fig. 11 ist insbesondere zu erkennen, daß zwischen den Haltearmen (47, 48) ein Klemmraum (54) zur Aufnahme des Werkstückes (5) angeordnet ist. Die Haltearme (47, 48) ragen mit Fixierungsvorsprüngen (55, 56) in den Klemmraum (54) hinein. Darüber hinaus weisen die Haltearme (47, 48) den Fixierungsvorsprüngen (55, 56) abgewandt angeordnete Arretierstege (57, 58) auf, die von Arretierelementen (59, 60), die vorzugsweise gemeinsam mit der Kammerwandung (18) positionierbar sind, in einer Arretierungsposition fixiert werden können.

Zur weiteren Abstützung und Fixierung des Werkstückes (5) weist das Halteelement (46) ein Anschlagelement (61) auf. Das Anschlagelement (1) begrenzt ein maximales Einführen des Werkstückes (5) in den Klemmraum (54). In der Arretierungspositionierung wird das Werkstück (5) von den Fixierungsvorsprüngen (55, 56) gegen das Anschlagelement (61) gedrückt. Das Anschlagelement (61) und die Fixierungsvorsprünge (55, 56) sind hierdurch auf einem etwa gleichen Höhenniveau angeordnet.

Aus Fig. 11 ist ebenfalls zu erkennen, daß das Halteelement (46) eine Grundplatte (62) aufweist, von der die Haltearme (47, 48) sowie die weiteren Bauelemente getragen sind. Die Grundplatte (62) kann über Distanzelemente (63, 64) sowie Verbindungselemente (65, 66) im Bereich der Tragplatte (41) und gemeinsam mit dieser im Bereich des Stationsrahmens (16) montiert werden. Insbesondere ist daran gedacht, eine Montage auf dem Kammersockel (30) durchzuführen.

Fig. 11 zeigt darüber hinaus, daß die Fixierungsvorsprünge (55, 56) jeweils mit Einführanschrägungen (67) und Auslaßanschrägungen (68) versehen sind. Bei einem Einführen der Werkstücke (5) in den Klemmraum (54) kommt das Werkstück (5) zunächst in Kontakt mit den Einführanschrägungen (67) und drückt die Haltearme (47, 48) entgegen der Kräfte der Federn (51, 52) auseinander. Nach einem vollständigem Einführen des Werkstückes (5) in den Klemmraum (54) kehren die Haltearme (47, 48) aufgrund der Kräfte der Federn (51, 52) automatisch in die Arretierungspositionierung zurück und drücken das Werkstück (5) gegen das Anschlagelement (61). Das Werkstück (5) ist hierdurch innerhalb der Plasmakammer (17) fixiert.

Nach einer Fertigstellung der Behandlung des Werkstückes (5) wird das Werkstück (5) von einem Transferelement ergriffen und gegen die Auslaßanschrägungen (68) gezogen. Die Auslaßanschrägung (68) ist vorzugsweise gekrümmt und mit einem Krümmungsverlauf entsprechend einer Außenkontur des Werkstückes (5) im Kontaktbereich ausgebildet. Die Haltearme (47, 48) werden hierdurch wieder auseinandergeführt und geben das Werkstück (5) frei. Insbesondere ist daran gedacht, das Transferelement mit gesteuerten Zangenarmen zu versehen. Die gesteuerten Zangenarme ermöglichen ein aktives Greifen der Werkstücke (5) und unterstützen die Aufbringung von Druckkräften und Zugkräften auf die Einführanschrägungen (67) bzw. die Auslaßanschrägungen (68). Insbesondere ist daran gedacht, die gesteuerten Zangen der Transferelemente auf einem im wesentlichen gleichen Höhenniveau wie die Haltearme (47, 48) bzw. auf einem etwas tieferen oder höheren Niveau auf das Werkstück (5) einwirken zu lassen. Hierdurch wird die Einleitung von Kippkräften in das Werkstück (5) vermieden bzw. stark vermindert.

Fig. 10 zeigt im linken Zeichnungsteil das Halteelement (46) nach einem Einsetzen eines flaschenartigen Werkstückes (5), das zwischen einem Stützring (69) und einem Schulterbereich (70) von den Haltearmen (47, 48) beaufschlagt ist. Eine Halterung eines derartigen flaschenartigen Werkstückes (5) im dargestellten Halsbereich führt zu einer sehr stabilen Fixierung des Werkstückes (5).

Gemäß der Darstellung in Fig. 11 trägt das Positionierelement (28) in einer Ebene unterhalb der Grundplatte (42) ein Sockelelement (71), das eine Ausnehmung (72) zur Aufnahme eines Mündungsbereiches der Werkstücke (5) aufweist. In der Ausnehmung (72) ist eine Dichtung (73) angeordnet, gegen die eine Begrenzungsfläche des Mündungsbereiches des Werkstückes (5) geführt werden kann.

Die Grundplatte (62) ist relativ zur Tragplatte (41) mit einem veränderlichen Abstand angeordnet. Zur Realisierung der verschieblichen Anordnung sind die Distanzelemente (63, 64) verschieblich bzw. teleskopierbar auf den Verbindungselementen (65, 66) geführt. Eine Grundpositionierung wird von Federn (74, 75) vorgegeben, die die Grundplatte (62) relativ zur Tragplatte (41) verspannen.

In einer Grundpositionierung ist ein Abstand zwischen der Grundplatte (62) und der Tragplatte (41) derart vorgegeben, daß das Werkstück (5) seitlich in das Halteelement (46) einsetzbar ist. Nach einem derartigen Einsetzen des Werkstückes (5) erfolgt eine Distanzverringerung zwischen der Grundplatte (62) und der Tragplatte (41), so daß der Mündungsbereich des Werkstückes (5) in die Ausnehmung (72) eingeführt wird. Die Distanzverringerung zwischen der Grundplatte (62) und der Tragplatte (41) wird so lange fortgesetzt, bis der Mündungsbereich des Werkstückes (5) gegen die Dichtung (73) geführt ist. Insbesondere ist daran gedacht, die Positionsveränderung der Grundplatte (62) von der Positionierbewegung der Kammerwandung (18) abzuleiten. Beispielsweise ist es möglich, ein geeignet geformtes Kontaktelement der Kammerwandung (18) gegen die Grundplatte (62) zu führen und hierdurch die Grundplatte (62) synchron mit der Positionierbewegung der Kammerwandung (18) in Richtung auf die Tragplatte (41) zu verschieben. Bei einer entgegengesetzten Bewegung der Kammerwandung (18) drücken die Federn (74, 75) die Grundplatte (62) wieder in die Ausgangspositionierung zurück.

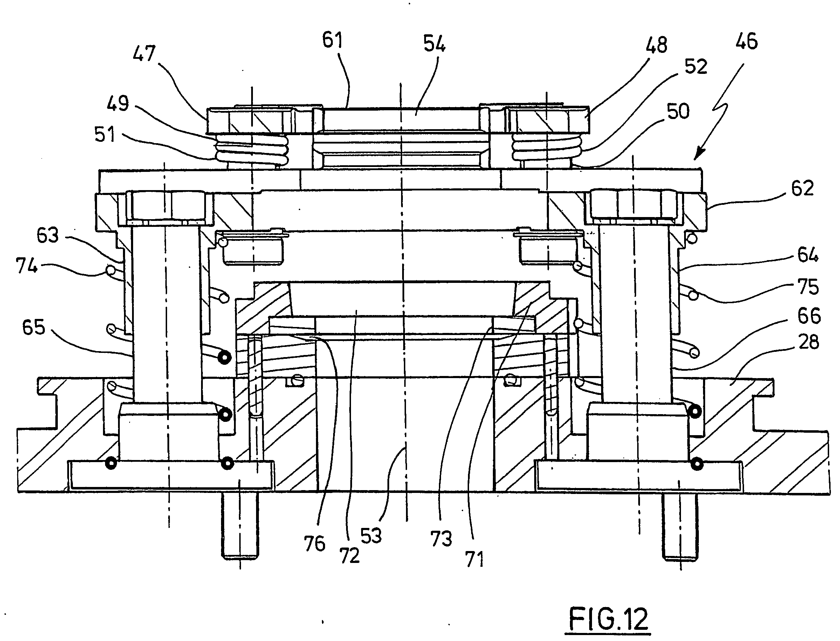

Fig. 12 zeigt einen Querschnitt durch die Anordnung gemäß Fig. 11. Insbesondere ist die Führung der hülsenförmigen Distanzelemente (63, 64) entlang der bolzenförmigen verbindungselemente (65, 66) veranschaulicht. Das Sockelelement (71) weist eine sich in Richtung der Kavitätenlängsachse (53) verjüngende Durchmessergestaltung auf. Hierdurch wird bei einem Absenken des Werkstückes (5) eine Selbstzentrierung durchgeführt. In einem abgesenkten Zustand des Werkstückes (5) wird dieses sowohl von den Haltearmen (47, 48) als auch vom Sockelelement (71) seitlich fixiert. Hierdurch wird eine kippsichere Anordnung des Werkstückes (5) innerhalb der Plasmastation (3) gewährleistet. Die Dichtung (73) wird vorzugsweise aus einem elastischen Material realisiert. Zur Vermeidung einer Behinderung der Positionierbewegung der Kammerwandung (18) weist die Dichtung (73) unterhalb des Bewegungsbereiches des Werkstückes (5) einen Ausgleichsraum (76) auf. Hierdurch werden sowohl eine Abdichtung des Werkstückes (5) als auch eine ausreichende Bewegungsfreiheit für die Kammerwandung (18) gewährleistet.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Zum Einsetzen des Werkstückes (5) wird das Werkstück (5) zunächst von einem Transferelement in den Klemmraum (54) eingesetzt. Nach einer Fixierung des Werkstückes (5) durch die Haltearme (47, 48) öffnet die gesteuerte Haltezange des Transferelementes und gibt das Werkstück (5) frei. Nach einem Abschluß des Einsetzvorganges wird die Kammerwandung (18) in ihre abgedichtete Positionierung abgesenkt und verschiebt im letzten Teil ihres Bewegungsvorganges die Grundplatte (62) in Richtung auf die Tragplatte (41). Hierdurch wird die Mündung des Werkstückes (5) in die Ausnehmung (72) eingeführt und abgedichtet werden. Anschließend wird zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen. Zur Ermöglichung einer seitlichen Positionierung des Werkstückes (5) wird die Grundplatte (62) durch die Federn (74, 75) wieder angehoben. Zur Durchführung der Entnahme des Werkstückes wird erneut ein Transferelement mit einer gesteuerten Zange im Bereich des Halteelementes (46) positioniert und die gesteuerte Zange des Transferelementes greift auf das Werkstück (5) zu. Das derart gehalterte Werkstück wird dann aus dem Halteelement (46) herausgezogen, wobei die Haltearme (47, 48) entgegen der Kräfte der Federn (51, 52) auseinander gedrückt werden.

Alternativ zur erläuterten Innenbeschichtung von Werkstükken (5) können auch Außenbeschichtungen, Sterilisationen oder Oberflächenaktivierungen durchgeführt werden. Bei derartigen Ausführungsformen ergreift das Halteelement (46) bei flaschenartigen Werkstücken (5) das Werkstück (5) vorzugsweise im Gewindebereich bzw. mit geringem Abstand zur Mündungsöffnung.

Eine Positionierung der Kammerwandung (18), des Dichtelementes (28) und / oder der Lanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

## Patentansprüche

1. Verfahren zur Plasmabehandlung von Werkstücken (5), bei dem das Werkstück (5) in eine zumindest teilweise evakuierbare Kammer (17) einer Behandlungsstation eingesetzt wird und bei dem das Werkstück (5) innerhalb der Behandlungsstation von einem Halteelement (46) positioniert wird, sowie bei dem das Werkstück (5) durch das Halteelement (46) derart beaufschlagt wird, daß das Werkstück (5) in Richtung einer Kavitätenlängsachse (53) positionsveränderlich geführt und in einer Behandlungspositionierung mit einem Mündungsbereich gegen eine Dichtung (73) gedrückt wird, **dadurch gekennzeichnet, daß** das Werkstück (5) durch mindestens zwei relativ zueinander positionierbare Klemmelemente des Halteelementes (46) derart beaufschlagt wird, daß das Werkstück (5) von einem Klemmraum (54) zwischen den Klemmelementen aufgenommen wird, daß die Positionierung der Klemmelemente in einer horizontalen Richtung durchgeführt wird und daß das Werkstück (5) von die Klemmelemente bereitstellenden zangenartigen Haltearmen (47, 48) positioniert wird und daß das Halteelement (46) durch eine Verschiebung einer Kammerwandung (18) der Plasmastation (3) positioniert wird.

2. Verfahren nach Anspruch 1, **dadurch gekennzeichnet, daß** eine Evakuierung einer Kavität (4) der Plasmastation (3) durch den Kammerboden (29) hindurch erfolgt.

3. Verfahren nach einem der Ansprüche 1 oder 2, **dadurch gekennzeichnet, daß** durch den Kammerboden (29) hindurch Prozeßgas zugeführt wird.

4. Verfahren nach einem der Ansprüche 1 bis 3, **dadurch gekennzeichnet, daß** das Prozeßgas durch eine Lanze (36) hindurch in einen Innenraum des Werkstückes (5) zugeführt wird.

5. Verfahren nach einem der Ansprüche 1 bis 4, **dadurch gekennzeichnet, daß** das Werkstück (5) von verschwenkbar gelagerten Haltearmen (47, 48) positioniert wird.

6. Verfahren nach Anspruch 5, **dadurch gekennzeichnet, daß** die Haltearme (47, 48) von Federn in eine Arretierungspositionierung gedrückt werden.

7. Verfahren nach einem der Ansprüche 1 bis 6, **dadurch gekennzeichnet, daß** die Haltearme (47, 48) bei einem Einführen des Werkstückes (5) in den Klemmraum (54) auseinander gedrückt werden.

8. Verfahren nach einem der Ansprüche 1 bis 7, **dadurch gekennzeichnet, daß** die Haltearme (47, 48) bei einem Herausziehen des Werkstückes (5) aus dem Klemmraum (54) auseinander gedrückt werden.

9. Verfahren nach einem der Ansprüche 1 bis 8, **dadurch gekennzeichnet, daß** Arretierungselemente (59, 60) zur Fixierung der Haltearme (47, 48) gemeinsam mit der Kammerwandung (18) positioniert werden.

10. Verfahren nach einem der Ansprüche 1 bis 9, **dadurch gekennzeichnet, daß** etwa auf einem gleichen Höhenniveau wie die Haltearme (47, 48) ein Anschlagelement (61) zur Fixierung des Werkstückes (5) angeordnet wird.

11. Verfahren nach einem der Ansprüche 1 bis 10, **dadurch gekennzeichnet, daß** im Bereich des Kammerdeckels (31) von einem Mikrowellengenerator (19) erzeugte Mikrowellen in die Kavität (4) eingeleitet werden.

12. Verfahren nach einem der Ansprüche 1 bis 11, **dadurch gekennzeichnet, daß** ein Werkstück (5) aus einem thermoplastischen Kunststoff behandelt wird.

13. Verfahren nach einem der Ansprüche 1 bis 12, **dadurch gekennzeichnet, daß** ein Innenraum eines hohlkörperartigen Werkstückes (5) behandelt wird.

14. Verfahren nach einem der Ansprüche 1 bis 13, **dadurch gekennzeichnet, daß** als Werkstück (5) ein Behälter behandelt wird.

15. Verfahren nach einem der Ansprüche 1 bis 14, **dadurch gekennzeichnet, daß** als Werkstück (5) eine Getränkeflasche behandelt wird.

16. Verfahren nach einem der Ansprüche 1 bis 15, **dadurch gekennzeichnet, daß** die mindestens eine Plasmastation (3) von einem rotierenden Plasmarad (2) von einer Eingabepositionierung in eine Ausgabepositionierung überführt wird.

17. Verfahren nach einem der Ansprüche 1 bis 16, **dadurch gekennzeichnet, daß** von einer Plasmastation (3) mehrere Kavitäten (4) bereitgestellt werden.

18. Verfahren nach einem der Ansprüche 1 bis 17, **dadurch gekennzeichnet, daß** das Werkstück (5) in einem Mündungsbereich von den Haltearmen (47, 48) fixiert wird.

19. Verfahren nach einem der Ansprüche 1 bis 18, **dadurch gekennzeichnet, daß** als Plasmabehandlung eine Plasmabeschichtung durchgeführt wird.

20. Verfahren nach einem der Ansprüche 1 bis 19, **dadurch gekennzeichnet, daß** die Plasmabehandlung unter Verwendung eines Niederdruckplasmas durchgeführt wird.

21. Verfahren nach einem der Ansprüche 1 bis 20, **dadurch gekennzeichnet, daß** eine Plasmapolymerisation durchgeführt wird.

22. Verfahren nach einem der Ansprüche 1 bis 21, **dadurch gekennzeichnet, daß** durch das Plasma mindestens zum Teil organische Substanzen abgeschieden werden.

23. Verfahren nach einem der Ansprüche 1 bis 22, **dadurch gekennzeichnet, daß** durch das Plasma mindestens zum Teil anorganische Substanzen abgeschieden werden.

24. Verfahren nach einem der Ansprüche 1 bis 23, **dadurch gekennzeichnet, daß** durch das Plasma eine Substanz zur Verbesserung von Barriereeigenschaften des Werkstückes (5) abgeschieden wird.

25. Verfahren nach Anspruch 24, **dadurch gekennzeichnet, daß** zusätzlich ein Haftvermittler zur Verbesserung eines Anhaftens der Substanz auf einer Oberfläche des Werkstückes (5) abgeschieden wird.

26. Verfahren nach einem der Ansprüche 1 bis 25, **dadurch gekennzeichnet, daß** in einer gemeinsamen Kavität mindestens zwei Werkstücke (5) gleichzeitig behandelt werden.

27. Verfahren nach einem der Ansprüche 1 bis 18, **dadurch gekennzeichnet, daß** als Plasmabehandlung eine Plasmasterilisation durchgeführt wird.

28. Verfahren nach einem der Ansprüche 1 bis 18, **dadurch gekennzeichnet, daß** als Plasmabehandlung eine Oberflächenaktivierung des Werkstückes (5) durchgeführt wird.

29. Verfahren nach einem der Ansprüche 1 bis 28, **dadurch gekennzeichnet, daß** das Halteelement (46) von mindestens einer Feder (74, 75) in einer Grundspositionierung gehalten wird.

30. Vorrichtung zur Plasmabehandlung von Werkstücken (5), die mindestens eine evakuierbare Plasmakammer (17) zur Aufnahme der Werkstücke (5) aufweist und bei der die Plasmakammer (17) im Bereich einer Behandlungsstation angeordnet ist, sowie bei der die Plasmakammer (17) von einem Kammerboden (29), einem Kammerdeckel (31) sowie einer seitlichen Kammerwandung (18) begrenzt ist und mindestens ein Halteelement (46) zur Positionierung des Werkstückes (5) aufweist, und bei der das Halteelement (46) mindestens in Richtung einer Kavitätenlängsachse (53) positionsveränderlich angeordnet ist, **dadurch gekennzeichnet, daß** ein als Teil des Halteelementes (46) ausgebildetes Sockelelement (71) eine Dichtung (73) zur Beaufschlagung eines Mündungsbereiches des Werkstückes (5) aufweist, daß das Halteelement (46) mindestens zwei relativ zueinander positionierbare Klemmelemente aufweist, die relativ zueinander mit einem einen Klemmraum (54) bereitstellenden Abstand zur Aufnahme des Werkstückes (5) angeordnet sind, daß die Klemmelemente in einer horizontalen Richtung positionierbar sind und daß die Klemmelemente von zangenartig angeordneten Haltearmen (47, 48) bereitgestellt sind und daß das Halteelement (46) von einer Kammerwandung (18) der Plasmastation (3) positionierbar ist.

31. Vorrichtung nach Anspruch 30, **dadurch gekennzeichnet, daß** für eine Evakuierung einer Kavität (4) der Plasmastation (3) im Kammerboden (29) mindestens ein vakuumkanal angeordnet ist.

32. Vorrichtung nach einem der Ansprüche 30 oder 31, **dadurch gekennzeichnet, daß** im Kammerboden (29) mindestens ein Kanal zur Zuführung von Prozeßgas angeordnet ist.

33. Vorrichtung nach einem der Ansprüche 30 bis 32, **dadurch gekennzeichnet, daß** zur Zuführung von Prozeßgas in einen Inneraum des Werkstückes (5) hinein eine Lanze (36) relativ zum Kammerboden (29) positionierbar angeordnet ist.

34. Vorrichtung nach einem der Ansprüche 30 bis 33, **dadurch gekennzeichnet, daß** die Haltearme (47, 48) relativ zu Drehachsen (49, 50) verschwenkbar angeordnet sind.

35. Vorrichtung nach einem der Ansprüche 30 bis 34, **dadurch gekennzeichnet, daß** die Haltearme (47, 48) mit einer Federverspannung in Richtung einer Arretierungspositionierung versehen sind.

36. Vorrichtung nach Anspruch 35, **dadurch gekennzeichnet, daß** die Federverspannungen von Schenkelfedern (51, 52) bereitgestellt sind.

37. Vorrichtung nach einem der Ansprüche 30 bis 36, **dadurch gekennzeichnet, daß** die Haltearme (47, 48) Fixierungsvorsprünge (55, 56) aufweisen, die jeweils mit einer Einführanschrägung (67) versehen sind.

38. Vorrichtung nach einem der Ansprüche 30 bis 37, **dadurch gekennzeichnet, daß** die Haltearme (47, 48) Fixierungsvorsprünge (55, 56) aufweisen, die jeweils mit einer Auslaßanschrägung (68) versehen sind.

39. Vorrichtung nach einem der Ansprüche 30 bis 38, **dadurch gekennzeichnet, daß** die Haltearme (47, 48) im Bereich ihrer den Fixierungsvorsprüngen (55, 56) abgewandten Ausdehnung mit Arretierstegen (57, 58) versehen sind.

40. Vorrichtung nach einem der Ansprüche 30 bis 39, **dadurch gekennzeichnet, daß** im Bereich des Kammerdeckels (31) ein Mikrowellengenerator (19) angeordnet ist.

41. Vorrichtung nach einem der Ansprüche 30 bis 40, **dadurch gekennzeichnet, daß** die Plasmastation (3) zur Beschichtung eines Werkstückes (5) aus einem thermoplastischen Kunststoff ausgebildet ist.

42. Vorrichtung nach einem der Ansprüche 30 bis 41, **dadurch gekennzeichnet, daß** die Plasmastation (3) zur Beschichtung eines behälterartigen Werkstückes (5) ausgebildet ist.

43. Vorrichtung nach einem der Ansprüche 30 bis 42, **dadurch gekennzeichnet, daß** die Plasmastation (3) zur Beschichtung eines Innenraumes eines hohlkörperartigen Werkstückes (5) ausgebildet ist.

44. Vorrichtung nach einem der Ansprüche 30 bis 43, **dadurch gekennzeichnet, daß** die Plasmastation (3) zur Beschichtung eines Werkstückes (5) in Form einer Getränkeflasche ausgebildet ist.

45. Vorrichtung nach einem der Ansprüche 30 bis 44, **dadurch gekennzeichnet, daß** die mindestens eine Plasmastation (3) von einem rotierenden Plasmarad (2) getragen ist.

46. Vorrichtung nach einem der Ansprüche 30 bis 45, **dadurch gekennzeichnet, daß** im Bereich der Plasmastation (3) mehrere Kavitäten (4) angeordnet sind.

47. Vorrichtung nach einem der Ansprüche 30 bis 46, **dadurch gekennzeichnet, daß** eine zur Bereitstellung von mindestens zwei Kavitäten (4) vorgesehene Kammerwandung (18) positionierbar angeordnet ist.

48. Vorrichtung nach einem der Ansprüche 30 bis 47, **dadurch gekennzeichnet, daß** die Arretierstege (57, 58) von Arretierelementen (59, 60) festsetzbar sind.

49. Vorrichtung nach Anspruch 48, **dadurch gekennzeichnet, daß** die Arretierelemente (59, 60) aus einem gehärteten Material ausgebildet sind.

50. Vorrichtung nach Anspruch 48 oder 49, **dadurch gekennzeichnet, daß** die Arretierelemente (59, 60) von der Kammerwandung (18) positionierbar sind.

51. Vorrichtung nach einem der Ansprüche 30 bis 50, **dadurch gekennzeichnet, daß** das Halteelement (46) mit einem Anschlagelement (61) für das Werkstück (5) versehen ist.

52. Vorrichtung nach einem der Ansprüche 30 bis 51, **dadurch gekennzeichnet, daß** die Fixierungsvorsprünge (55, 56) und das Anschlagelement (61) auf einem etwa gleichen Höhenniveau angeordnet sind.

53. Vorrichtung nach einem der Ansprüche 30 bis 52, **dadurch gekennzeichnet, daß** das Anschlagelement (61) und die Fixierungsvorsprünge (55, 56) auf einem Höhenniveau zur Beaufschlagung eines Mündungsbereiches eines flaschenförmigen Werkstückes (5) angeordnet sind.

54. Vorrichtung nach einem der Ansprüche 30 bis 53, **dadurch gekennzeichnet, daß** das Anschlagelement (61) und die Fixierungsvorsprünge (55, 56) auf einem Höhenniveau zur Beaufschlagung eines flaschenförmigen Werkstückes (5) zwischen dessen Stützring (69) und dessen Schulterbereich (70) angeordnet sind.

55. Vorrichtung nach einem der Ansprüche 30 bis 54, **dadurch gekennzeichnet, daß** das Halteelement (46) mindestens eine Feder (74, 75) zur Positionierung in einem Ausgangszustand aufweist.

56. Vorrichtung nach einem der Ansprüche 30 bis 55, **dadurch gekennzeichnet, daß** die Dichtung (73) als ein Dichtring ausgebildet ist.

57. Vorrichtung nach einem der Ansprüche 30 bis 56, dadurch gekenntzeichnet, daß das Sockelelement (71) mit einer Seitenführung für das Werkstück (5) versehen ist.

## Claims

1. A method for plasma treatment of work pieces (5), wherein the work piece (5) is inserted in an at least partially evacuable chamber (17) of a treatment station and wherein the work piece (5) is positioned inside the treatment station by a holding element (46), and wherein the work piece (5) is impinged by the holding element (46) in such a way, that the work piece (5) is guided in the direction of a longitudinal axis of a cavity (53) in a position-changing manner, and in a treatment positioning its mouth is pushed against a seal (73), **characterised in that** the work piece (5) is impinged by at least two clamping elements of the holding element (46) which can be positioned relative to one another in such a way that the work piece (5) is received by a clamping space (54) between the clamping elements, so that positioning of the clamping elements is carried out in a horizontal direction and that the work piece (5) is positioned by forcipate holding arms (47, 48) providing the clamping elements and that the holding element (46) is positioned through a displacement of a chamber wall (18) of the plasma station (3).

2. The method according to claim 1, **characterised in that** a cavity (4) of the plasma station (3) is evacuated through the chamber base (29).

3. The method according to one of claims 1 or 2, **characterised in that** process gas is supplied through the chamber base (29).

4. The method according to one of claims 1 to 3, **characterised in that** the process gas is supplied into an interior of the work piece (5) through a lance (36).

5. The method according to any one of claims 1 to 4, **characterised in that** the work piece (5) is positioned by pivotally mounted holding arms (47, 48).

6. The method according to claim 5, **characterised in that** the holding arms (47, 48) are pushed in an arresting positioning by springs.

7. The method according to any one of claims 1 to 6, **characterised in that** the holding arms are pushed apart upon introducing the work piece (5) into the clamping space (54).

8. The method according to any one of claims 1 to 7, **characterised in that** the holding arms (47, 48) are pushed apart upon pulling the work piece (5) out of the clamping space (54).

9. The method according to any one of claims 1 to 8, **characterised in that** arresting elements (59, 60) for fixing the holding arms (47, 48) are positioned together with the chamber wall (18).

10. The method according to any one of claims 1 to 9, **characterised in that** a stop element (61) for fixing the work piece (5) is arranged at an approximately same height level as the holding arms (47, 48).

11. The method according to any one of claims 1 to 10, **characterised in that** microwaves generated by a microwave generator are passed into the cavity (4) in the area of the chamber cover (31).

12. The method according to any one of claims 1 to 11, **characterised in that** a work piece (5) made of a thermoplastic material is treated.

13. The method according to any one of claims 1 to 12, **characterised in that** an interior of a hollow body-like work piece (5) is treated.

14. The method according to any one of claims 1 to 13, **characterised in that** a container is treated as work piece (5).

15. The method according to any one of claims 1 to 14, **characterised in that** a beverage bottle is treated as workpiece (5).

16. The method according to any one of claims 1 to 15, **characterised in that** at least one plasma station (3) is moved from an input position to an output position by a rotating plasma wheel (2).

17. The method according to any one of claims 1 to 16, **characterised in that** a plasma station (3) is providing several cavities (4).

18. The method according to any one of claims 1 to 17, **characterised in that** the work piece (5) is fixed by the holding arms (47, 48) in a mouth area.

19. The method according to any one of claims 1 to 18, **characterised in that** a plasma coating is performed as plasma treatment.

20. The method according to any one of claims 1 to 19, **characterised in that** the plasma treatment is performed using a low-pressure plasma.

21. The method according to any one of claims 1 to 20, **characterised in that** a plasma polymerization is performed.

22. The method according to any one of claims 1 to 21, **characterised in that** at least partially organic substances are deposited by the plasma.

23. The method according to any one of claims 1 to 22, **characterised in that** at least partially inorganic substances are deposited by the plasma.

24. The method according to any one of claims 1 to 23, **characterised in that** a substance for improving the barrier properties of the work piece (5) is deposited by the plasma.

25. The method according to claim 24, **characterised in that** additionally an adhesion promoter for improving the adhesion of the substance on a surface of the work piece (5) is deposited.

26. The method according to any one of claims 1 to 25, **characterised in that** at least two work pieces (5) are treated simultaneously in a common cavity.

27. The method according to any one of claims 1 to 18, **characterised in that** a plasma sterilisation is performed as plasma treatment.

28. The method according to any one of claims 1 to 18, **characterised in that** a surface activation of the work piece (5) is performed as plasma treatment.

29. The method according to any one of claims 1 to 28, **characterised in that** the holding element (46) is held by at least one spring (74, 75) in a basic positioning.

30. A device for plasma treatment of work pieces (5) comprising at least one evacuable plasma chamber (17) for receiving the work pieces (5), and wherein the plasma chamber (17) is arranged in the area of a treatment station, and wherein the plasma chamber (17) is bounded by a chamber base (29), a chamber cover (31) and a lateral chamber wall (18) and comprising at least one holding element (46) for positioning the work piece (5), and wherein the holding element (46) is arranged at least in the direction of a longitudinal axis of a cavity in a position-changing manner, **characterised in that** a base element (71) formed as a part of the holding element (46) comprises a seal (73) for impinging a mouth area of the work piece (5), so that the holding element (46) comprises at least two clamping elements which can be positioned relative to one another, which are arranged relative to one another at a distance providing a clamping space (54) for receiving the work piece (5), so that the clamping elements can be positioned in a horizontal direction and the clamping elements are provided by forcipately arranged holding arms (47, 48) and the holding element (46) can be positioned from a chamber wall (18) of the plasma station (3).

31. The device according to claim 30, **characterised in that** for evacuation of a cavity (4) of the plasma station (3) at least one vacuum channel is arranged in the chamber base (29).

32. The device according to any one of claims 30 or 31, **characterised in that** at least one channel for supplying process gas is arranged in the chamber base (29).

33. The device according to any one of claims 30 to 32, **characterised in that** a lance (36) is arranged so that it can be positioned relative to the chamber base (29) for supplying process gas to an interior of the work piece (5).

34. The device according to any one of claims 30 to 33, **characterised in that** the holding arms (47, 48) are pivotably arranged relative to axes of rotation (49, 50).

35. The device according to any one of claims 30 to 34, **characterised in that** the holding arms (47, 48) are provided with a spring tension in the direction of an arresting positioning.

36. The device according to claim 35, **characterised in that** the spring tension is provided by torsion springs (51, 52).

37. The device according to any one of claims 30 to 36, **characterised in that** the holding arms (47, 48) are comprising fixing protrusions (55, 56) which in each case are provided with an insertion bevel (67).

38. The device according to any one of claims 30 to 37, **characterised in that** the holding arms (47, 48) are comprising fixing protrusions (55, 56) which in each case are provided with an outlet bevel (68).

39. The device according to any one of claims 30 to 38, **characterised in that** the holding arms (47, 48) are provided with arresting webs (57, 58) in the area of their extension facing away from the fixing protrusions (55, 56).

40. The device according to any one of claims 30 to 39, **characterised in that** a microwave generator (19) is arranged in the area of the chamber cover (31).

41. The device according to any one of claims 30 to 40, **characterised in that** the plasma station (3) is formed for coating a work piece (5) made of a thermoplastic material.

42. The device according to any one of claims 30 to 41, **characterised in that** the plasma station (3) is formed for coating a container-like work piece (5).

43. The device according to any one of claims 30 to 42, **characterised in that** the plasma station (3) is formed for coating an interior of a hollow body-like work piece (5).

44. The device according to one of claims 30 to 43, **characterised in that** the plasma station (3) is formed for coating a work piece (5) in the form of a beverage bottle.

45. The device according to any one of claims 30 to 44, **characterised in that** the at least one plasma station (3) is supported by a rotating plasma wheel (2).

46. The device according to any one of claims 30 to 45, **characterised in that** several cavities (4) are arranged in the area of the plasma station (3).

47. The device according to any one of claims of 30 to 46, **characterised in that** a chamber wall (18) which is provided for providing at least two cavities (4) is arranged such that it can be positioned.

48. The device according to any one of claims 30 to 47, **characterised in that** the arresting webs (57, 58) can be fixed by arresting elements (59, 60).

49. The device according to claim 48, **characterised in that** the arresting elements (59, 60) are formed by a hardened material.

50. The device of claim 48 or 49, **characterised in that** the arresting elements (59, 60) can be positioned by the chamber wall (18).

51. The device according to any one of claims 30 to 50, **characterised in that** the holding element (46) is provided with a stop element (61) for the work piece (5).

52. The device according to any one of claims 30 to 51, **characterised in that** the fixing protrusions (55, 56) and the stop element (61) are arranged at an approximately same height level.

53. The device according to any one of claims 30 to 52, **characterised in that** the stop element (61) and the fixing protrusions (55, 56) are arranged at a height level for impinging a mouth area of a bottle-shaped work piece (5).

54. The device according to any one of claims 30 to 53, **characterised in that** the stop element (61) and the fixing protrusions (55, 56) are arranged at a height level for impinging a bottle-shaped work piece (5) between its support ring (69) and its shoulder area (70).

55. The device according to any one of claims 30 to 54, **characterised in that** the holding element (46) comprises at least one spring (74, 75) for positioning in an initial state.

56. The device according to any one of claims 30 to 55, **characterised in that** the seal (73) formed as a sealing ring.

57. The device according to any one of claims 30 to 56, **characterised in that** the base element (71) is provided with a lateral guide for the work piece (5).

## Revendications

1. Procédé de traitement au plasma de pièces d'oeuvre (5) dans le cadre duquel la pièce (5) est introduite dans une chambre (17) d'une station de traitement, cette chambre pouvant, en partie au moins, être évacuée, et dans le cadre duquel la pièce (5) est positionnée à l'intérieur de la station de traitement par un élément de maintien (46), et dans le cadre duquel la pièce (5) est saisie par l'élément de maintien (46) de façon à être guidée avec un positionnement variable dans le sens d'un axe longitudinal (53) de la cavité et, en un positionnement de traitement, être pressée avec une section d'embouchure contre un joint (73), **caractérisé en ce que** la pièce (5) est saisie par au moins deux éléments de serrage de l'élément de maintien (46), positionnables relativement l'un par rapport à l'autre, de façon telle que la pièce (5) se loge dans un espace de serrage (54) entre les éléments de serrage, et que le positionnement des éléments de serrage est effectué en un sens horizontal, et que la pièce (5) est positionnée par des bras de support (47, 48) de type pince mettant à disposition les éléments de serrage, et que l'élément de maintien (46) est positionné par un déplacement d'une paroi de chambre (18) de la station de plasma (3).

2. Procédé selon la revendication 1, **caractérisé en ce qu**'une évacuation d'une cavité (4) de la station de plasma (3) a lieu à travers le fond (29) de la chambre.

3. Procédé selon l'une des revendications 1 à 2, **caractérisé en ce qu**'un gaz de procédé est introduit par le fond (29) de la chambre.

4. Procédé selon l'une des revendications 1 à 3, **caractérisé en ce que** le gaz de procédé est introduit par une lance (36) dans un espace intérieur de la pièce d'oeuvre (5).

5. Procédé selon l'une des revendications 1 à 4, **caractérisé en ce que** la pièce d'oeuvre (5) est positionnée par des bras de support (47, 48) logés de façon à pouvoir pivoter.

6. Procédé selon la revendication 5, **caractérisé en ce que** les bras de support (47, 48) sont pressés par des ressorts en une position d'arrêt.

7. Procédé selon l'une des revendications 1 à 6, **caractérisé en ce qu**'une pression est exercée sur les bras de support (47, 48) pour les écarter lors d'une introduction de la pièce d'oeuvre (5) dans l'espace de serrage (54).

8. Procédé selon l'une des revendications 1 à 7, **caractérisé en ce qu**'une pression est exercée sur les bras de support (47, 48) pour les écarter lors d'une extraction de la pièce d'oeuvre (5) hors de l'espace de serrage (54).

9. Procédé selon l'une des revendications 1 à 8, **caractérisé en ce que** des éléments d'arrêt (59, 60) peuvent être positionnés conjointement avec la paroi de la chambre (18) pour fixer les bras de support (47, 48).

10. Procédé selon l'une des revendications 1 à 9, **caractérisé en ce qu**'un élément de butée (61) destiné à fixer la pièce d'oeuvre (5) est agencé à peu près au même niveau de hauteur que les bras de support (47, 48).

11. Procédé selon l'une des revendications 1 à 10, **caractérisé en ce que** des micro-ondes produites par un générateur de micro-ondes (19) au niveau du couvercle (31) de la chambre sont introduites dans la cavité (4).

12. Procédé selon l'une des revendications 1 à 11, **caractérisé en ce qu**'est traitée une pièce d'oeuvre (5) en matière plastique thermoplastique.

13. Procédé selon l'une des revendications 1 à 12, **caractérisé en ce qu**'un espace intérieur d'une pièce d'oeuvre (5) creuse est traité.

14. Procédé selon l'une des revendications 1 à 13, **caractérisé en ce que** la pièce d'oeuvre (5) traitée est un récipient.

15. Procédé selon l'une des revendications 1 à 14, **caractérisé en ce que** la pièce d'oeuvre (5) traitée est une bouteille pour boissons.

16. Procédé selon l'une des revendications 1 à 15, **caractérisé en ce que** la ou les station(s) de plasma (3) est ou sont déplacée(s) d'un positionnement d'introduction en un positionnement de sortie par une roue de traitement au plasma (2) en rotation.

17. Procédé selon l'une des revendications 1 à 16, **caractérisé en ce que** plusieurs cavités (4) sont mises à disposition par une station de plasma (3).

18. Procédé selon l'une des revendications 1 à 17, **caractérisé en ce que** la pièce d'oeuvre (5) est fixée au niveau d'une section d'embouchure par les bras de support (47, 48).

19. Procédé selon l'une des revendications 1 à 18, **caractérisé en ce que** le traitement au plasma est réalisé sous forme de revêtement par plasma.

20. Procédé selon l'une des revendications 1 à 19, **caractérisé en ce que** le traitement au plasma fait appel à un plasma basse pression.

21. Procédé selon l'une des revendications 1 à 20, **caractérisé en ce que** l'on effectue une polymérisation par plasma.

22. Procédé selon l'une des revendications 1 à 21, **caractérisé en ce que** le plasma dépose en partie au moins des substances organiques.

23. Procédé selon l'une des revendications 1 à 22, **caractérisé en ce que** le plasma dépose en partie au moins des substances anorganiques.

24. Procédé selon l'une des revendications 1 à 23, **caractérisé en ce que** le plasma dépose une substance améliorant les propriétés de barrière de la pièce d'oeuvre (5).

25. Procédé selon la revendication 24, **caractérisé en ce qu**'est en outre déposé un agent de pontage pour améliorer l'adhésion de la substance à la surface de la pièce (5).

26. Procédé selon l'une des revendications 1 à 25, **caractérisé en ce que** deux pièces d'oeuvre (5) au moins sont traitées simultanément dans une cavité commune.

27. Procédé selon l'une des revendications 1 à 18, **caractérisé en ce que** le traitement au plasma appliqué est une stérilisation par plasma.

28. Procédé selon l'une des revendications 1 à 18, **caractérisé en ce que** le traitement au plasma appliqué est une activation de surface de la pièce d'oeuvre (5).

29. Procédé selon l'une des revendications 1 à 28, **caractérisé en ce que** l'élément de maintien (46) est maintenu en un positionnement de base par au moins un ressort (74, 75).

30. Dispositif de traitement au plasma de pièces d'oeuvre (5) présentant, pour recevoir ces pièces (5), au moins une chambre à plasma (17) pouvant être évacuée agencée dans la zone d'une station de traitement, cette chambre à plasma (17) étant délimitée par un fond de chambre (29), un couvercle de chambre (31) ainsi qu'une paroi latérale (18) et munie d'au moins un élément de maintien (46) assurant le positionnement de la pièce d'oeuvre (5), et dont l'élément de maintien (46) est agencé de façon à ce que sa position puisse au moins être modifiée dans le sens d'un axe longitudinal (53) de la cavité, **caractérisé en ce qu'**un élément de socle (71) réalisé comme partie de l'élément de maintien (46) présente un joint (73) pour s'appuyer contre une section d'embouchure de la pièce d'oeuvre (5), que l'élément de maintien (46) présente au moins deux éléments de serrage positionnables relativement l'un par rapport à l'autre, lesquels sont agencés à une distance l'un de l'autre de façon à réserver entre eux un espace de serrage (54) recevant la pièce d'oeuvre (5), que les éléments de serrage sont positionnables selon une direction horizontale, et **en ce que** les éléments de serrage sont mis à disposition par des bras de support (47, 48) agencés pour former une pince, et que l'élément de maintien (46) peut être positionné par une paroi de chambre (18) de la station de plasma (3).

31. Dispositif selon la revendication 30, **caractérisé en ce qu**'un canal à vide au moins est aménagé dans le fond (29) de la chambre pour l'évacuation d'une cavité (4) de la station de plasma (3).

32. Dispositif selon l'une des revendications 30 ou 31, **caractérisé en ce qu**'un canal au moins est aménagé dans le fond (29) de la chambre pour l'adduction d'un gaz de procédé.

33. Dispositif selon l'une des revendications 30 à 32, **caractérisé en ce qu**'une lance (36) pour l'adduction d'un gaz de procédé dans un espace intérieur de la pièce d'oeuvre (5) est agencée de façon à pouvoir être positionnée par rapport au fond (29) de la chambre.

34. Dispositif selon l'une des revendications 30 à 33, **caractérisé en ce que** les bras de support (47, 48) sont agencés de façon à pouvoir pivoter par rapport à des axes de rotation (49, 50).

35. Dispositif selon l'une des revendications 30 à 34, **caractérisé en ce que** les bras de support (47, 48) sont dotés d'un système exerçant une force de ressort en direction d'un positionnement d'arrêt.

36. Dispositif selon la revendication 35, **caractérisé en ce que** les forces de ressort sont exercées par des ressorts à branches (51, 52).

37. Dispositif selon l'une des revendications 30 à 36, **caractérisé en ce que** les bras de support (47, 48) présentent des saillies de fixation (55, 56), lesquelles sont respectivement dotées d'un chanfrein d'introduction (67).

38. Dispositif selon l'une des revendications 30 à 37, **caractérisé en ce que** les bras de support (47, 48) présentent des saillies de fixation (55, 56), lesquelles sont respectivement dotées d'un chanfrein de sortie (68).

39. Dispositif selon l'une des revendications 30 à 38, **caractérisé en ce que** les bras de support (47, 48) sont dotés dans la partie de leur extension opposée aux saillies de fixation (55, 56) de pièces d'arrêt (57, 58).

40. Dispositif selon l'une des revendications 30 à 39, **caractérisé en ce qu**'un générateur de micro-ondes (19) est placé au niveau du couvercle (31) de la chambre.

41. Dispositif selon l'une des revendications 30 à 40, **caractérisé en ce que** la station de plasma (3) est conçue pour appliquer un revêtement d'une matière plastique thermoplastique à l'intérieur d'une pièce d'oeuvre (5).

42. Dispositif selon l'une des revendications 30 à 41, **caractérisé en ce que** la station de plasma (3) est conçue pour appliquer un revêtement à l'intérieur d'une pièce d'oeuvre (5) en forme de récipient.

43. Dispositif selon l'une des revendications 30 à 42, **caractérisé en ce que** la station de plasma (3) est conçue pour appliquer un revêtement à l'intérieur d'une pièce d'oeuvre (5) creuse.

44. Dispositif selon l'une des revendications 30 à 43, **caractérisé en ce que** la station de plasma (3) est conçue pour appliquer un revêtement à l'intérieur d'une pièce d'oeuvre (5) en forme de bouteille pour boissons.

45. Dispositif selon l'une des revendications 30 à 44, **caractérisé en ce que** la ou les station(s) de plasma (3) est ou sont portée(s) par une roue de traitement au plasma (2) en rotation.

46. Dispositif selon l'une des revendications 30 à 45, **caractérisé en ce que** plusieurs cavités (4) sont agencées dans la zone de la station de plasma (3).

47. Dispositif selon l'une des revendications 30 à 46, **caractérisé en ce qu**'une paroi (18) prévue pour mettre à disposition au moins deux cavités (4) est agencée de façon à pouvoir être positionnée.

48. Dispositif selon l'une des revendications 30 à 47, **caractérisé en ce que** les pièces d'arrêt (57, 58) peuvent être fixées par des éléments d'arrêt (59, 60).

49. Dispositif selon la revendication 48, **caractérisé en ce que** les éléments d'arrêt (59, 60) sont réalisés en un matériau durci.

50. Dispositif selon la revendication 48 ou 49, **caractérisé en ce que** les éléments d'arrêt (59, 60) peuvent être positionnés par la paroi de chambre (18).

51. Dispositif selon l'une des revendications 30 à 50, **caractérisé en ce que** l'élément de maintien (46) est doté d'un élément de butée (61) pour la pièce d'oeuvre (5).

52. Dispositif selon l'une des revendications 30 à 51, **caractérisé en ce que** les saillies de fixation (55, 56) et l'élément de butée (61) sont agencés à peu près au même niveau de hauteur.

53. Dispositif selon l'une des revendications 30 à 52, **caractérisé en ce que** l'élément de butée (61) et les saillies de fixation (55, 56) sont agencés à un même niveau de hauteur où ils agissent sur une section d'embouchure d'une pièce d'oeuvre (5) en forme de bouteille.

54. Dispositif selon l'une des revendications 30 à 53, **caractérisé en ce que** l'élément de butée (61) et les saillies de fixation (55, 56) sont agencés à un même niveau de hauteur pour agir sur une pièce d'oeuvre (5) en forme de bouteille entre la bague d'appui (69) et l'épaulement (70) de cette pièce.

55. Dispositif selon l'une des revendications 30 à 54, **caractérisé en ce que** l'élément de maintien (46) présente au moins un ressort (74, 75) pour le positionnement en un état initial.

56. Dispositif selon l'une des revendications 30 à 55, **caractérisé en ce que** le joint (73) est réalisé sous forme de bague d'étanchéité.

57. Dispositif selon l'une des revendications 30 à 56, **caractérisé en ce que** l'élément de socle (71) est doté d'un guidage latéral pour la pièce d'oeuvre (5).
